Europäisches Patentamt

European Patent Office

Office européen des brevets

(19)

(11) Publication number: **0 003 034**
**B1**

(12) **EUROPEAN PATENT SPECIFICATION**

(45) Veröffentlichungstag der Patentschrift: **03.02.82**

(21) Anmeldenummer: **78101769.4**

(22) Anmeldetag: **19.12.78**

(51) Int. Cl.³: **H 01 L 23/10, C 03 C 29/00**

(54) Gehäuse für eine Leistungshalbleiterbauelement.

(30) Priorität: **09.01.78 DE 2800696**

(43) Veröffentlichungstag der Anmeldung:
**25.07.79 Patentblatt 79/15**

(45) Bekanntmachung des Hinweises auf die Patenterteilung:
**03.02.82 Patentblatt 82/5**

(84) Benannte Vertragsstaaten:
**FR GB IT SE**

(56) Entgegenhaltungen:
**DE - A - 1 439 099**
**US - A - 2 794 059**
**US - A - 3 331 913**
**US - A - 3 433 515**

(73) Patentinhaber: **SIEMENS AKTIENGESELLSCHAFT**
**Berlin und München**
**Postfach 22 02 61**
**D-8000 München 22 (DE)**

(72) Erfinder: **Vogt, Herbert**
**Maximilianstrasse 46**
**D-8000 München 22 (DE)**
Erfinder: **Wassill, Lothar**
**Schumacherring 21**
**D-8000 München 83 (DE)**
Erfinder: **Wengler, Christian**
**Milbertshofener Platz 17**
**D-8000 München 40 (DE)**

Courier Press, Leamington Spa, England.

## Gehäuse für ein Leistungshalbleiterbauelement

Die vorliegende Erfindung bezieht sich auf ein Gehäuse für ein Leistungshalbleiterbauelement mit einem in einer Öffnung eines metallenen Gehäuseteiles sitzenden Glasteil, mit einem außerhalb des metallenen Gehäuseteiles sitzenden Keramikring, dessen Außendurchmesser größer als der Außendurchmesser des Glasteiles ist und der mindestens an einer Stirnseite mit einer Stirnseite des Glasteiles verschmolzen ist, und mit mindestens einem elektrischen Leiter, der durch das Glasteil und den Keramikring hindurchgeht.

En solches Gehäuse ist zum Beispiel im USpatent 3 331 913 beschrieben worden. Mit dem angeschmolzenen Keramikring können der Kriechweg zwischen dem metallenen Gehäuseteil und den elektrischen Leitern vergrößert und die dielektrischen Eigenschaften der Oberfläche des Gehäuseteiles verbessert werden. Das Glasteil des bekannten Gehäuses hat für jeden elektrischen Leiter einen rohrstutzenförmigen Ansatz, der den elektrischen Leiter umgibt. Diese Ansätze ragen über das metallene Gehäuseteil hinaus. Der Keramikring hat seinerseits Ausnehmungen, die der Form der rohrförmigen Ansätze genau angepaßt sind. Die Glasverschmelzung liegt bei diesem Gehäuse an den Grenzflächen zwischen Keramikring und Metallteil sowie an den Grenzflächen zwischen Keramikring und den elektrischen Leitern. Die Glasdurchführung und der Keramikring sind in ihrer Form einander angepaßt, was ein aufwendiges Herstellverfahren für beide Teile voraussetzt.

Der Erfindung liegt die Aufgabe zugrunde, ein Gehäuse der oben beschriebenen Art so weiterzubilden, daß eine Kriechwegverlängerung mit einfacher geformten Teilen möglich ist.

Die Erfindung ist dadurch gekennzeichnet, daß die Stirnseite des Keramikringes und die Stirnseite des Glasteiles eben ausgebildet sind,

daß der Durchmesser des Keramikringes an der genannten Stirnseite kleiner als der Durchmesser des Glasteiles ist,

daß zwischen der Stirnseite des Keramikringes und seinem Rand zur Bildung eines Kapillarspaltes für die Verschmelzung eine Abschrägung liegt

und daß zwischen der Stirnseite des Keramikringes und dem elektrischen Leiter ein beim Verschmelzen zur Füllung mit Glas bestimmter Zwischenraum liegt.

In der deutschen Offenlegungsschrift 14 39 099 ist zwar bereits ein Gehäuse für Leistungshalbleiterbauelement beschrieben worden, bei dem ein eine Abschrägung aufweisender Keramikring verwendet wird. Dieser Keramikring wird jedoch durch Kleben mit dem elektrischen Leiter, dem Glasteil und dem metallenen Gehäuseteil verbunden. Eine solche Verbindung hat sich jedoch als nicht temperaturwechselfest erwiesen. Die Bildung eines Kapillarsplates spielt hierbei keine Rolle, demgemäß ist auch der Durchmesser des Keramikringes an der Stirnseite größer als der Durchmesser des Glasteiles. Zur Füllung mit Glas bestimmte Zwischenräume zwischen Keramikring und elektrischen Leiter sind hier ebenfalls nicht vorgesehen.

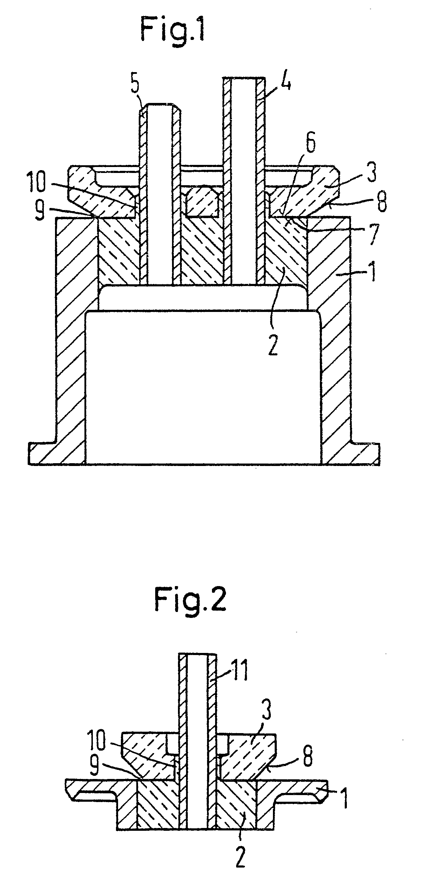

Die Erfindung wird an Hand zweier Ausführungsbeispiele in Verbindung mit den Fig. 1 und 2 näher erläutert. Es zeigen:

Fig. 1 den Schnitt durch ein Gehäuse für ein Leistungshalbleiterbauelement mit einer Durchführung für zwei Leiter und

Fig. 2 den Schnitt durch eine Durchführung mit einem Leiter.

In Fig. 1 ist ein metallenes Gehäuseteil mit 1 bezeichnet. Dieses Gehäuseteil ist Teil eines Halbleiterbauelementes. Es kann beispielsweise aus Stahl bestehen. Die Durchführung weist ein Glasteil 2 auf, in dem Leiter 4 und 5 sitzen. Auf dem Glasteil 2 sitzt ein Isolierkörper 3, der beispielsweise ein Keramikring sein kann. Der Isolierkörper 3 ist an einer seiner Stirnseiten 6 an eine Stirnseite 7 des Glasteiles 2 angeschmolzen. Die Stirnseite 6 des Isolierkörpers 3 ist mit einer Abschrägung 8 versehen, so daß der Durchmesser des Isolierkörpers 3 an seiner Stirnseite 6 kleiner als der Durchmesser des Glasteiles 2 ist. Damit bildet die Abschrägung 8 im nicht geschmolzenen Zustand mit dem Glasteil 2 einen Kapillarspalt 9. Der Isolierkörper 3 weist Öffnungen auf, deren Durchmesser um so viel größer als der Außendurchmesser der Leiter 4, 5 ist, daß der Zwischenraum 10 zwischen diesen Leitern und den Flächen der Öffnungen mit Glas ausgefüllt werden kann.

Die Einzelteile der Durchführung werden in einer Schmelzform miteinander verschmolzen. Dazu werden die Teile wie in Fig. 1 dargestellt zusammengefügt und kopfüber in eine Schmelzform gelegt, die beispielsweise aus Graphit besteht. Beim Schmelzen des Glasteiles 2 verbindet sich dieses mit dem metallenen Gehäuseteil 1, den Leitern 4, 5 und dem Isolierkörper 3. Das Glas fließt dabei in die Kapillarspalte 9 und zum Teil in den Zwischenraum 10 und sorgt so für eine hermetisch dichte und mechanisch stabile Verbindung zwischen den Einzelteilen der Durchführung.

Die Leiter 4, 5 wurden als Metallröhrchen dargestellt. Zur elektrischen Verbindung des Halbleiterkörpers in Inneren des Gehäuses werden durch die Röhrchen Drähte, Kabel oder Bolzen gesteckt, die mit dem Röhrchen durch Verquetschen, Verlöten oder Verschweißen gasdicht verbunden werden. Es ist jedoch auch möglich, anstelle der Leiter 4, 5 direkt die Drähte, Kabel oder Bolzen einzuschmelzen.

Der Isolierkörper und das Glasteil sind zweckmäßigerweise rund ausgebildet und konzentrisch zueinander angeordnet. Damit ergibt sich eine optimale Verlängerung des Kriechweges.

In Fig. 2 ist eine Durchfürung mit nur einem Leiter 11 dargestellt. Gleiche Teile oder Teile mit gleicher Funktion wie in Fig. 1 sind mit gleichen Bezugsziffern versehen. Das metallene Gehäuseteil 1 ist hier als Schweißring ausgebildet, der auf den Rand einer Öffnung eines metallenen Gehäuseteiles, für ein Halbleiterbauelement, aufgesetzt und mit diesem verschweißt ist. Die Durchführung nach Fig. 2 kann auf gleiche Weise wie die Durchführung nach Fig. 1 hergestellt werden.

Zweckmäßig ist es, den Isolierkörper 3 als Anglasungsform auszubilden. Für beide Ausführungen gilt, daß das Volumen des Glasteiles so groß gewählt werden muß, daß eine vollständige Benetzung zwischen dem geschmolzenen Glas und der Stirnseite 6 des Isolierkörpers gewährleistet ist.

## Patentansprüche

1. Gehäuse für ein Leistungshalbleierbauelement mit einem in einer Öffnung eines metallenen Gehäuseteiles (1) sitzenden Glasteil (2), mit einem außerhalb des metallenen Gehäuseteiles sitzenden Keramikring (3), dessen Außendurchmesser größer als der Außendurchmesser des Glasteiles ist und der mindestens an einer Stirnseite (6) mit einer Stirnseite (7) des Glasteiles verschmolzen ist, und mit mindestens einem elektrischen Leiter (4, 5), der durch das Glasteil und den Keramikring hindurchgeht, dadurch gekennzeichnet, daß die Stirnseite (6) des Keramikringes (3) und die Stirnseite (7) des Glasteiles (2) eben ausgebildet sind, daß der Durchmesser des Keramikringes an der genannten Stirnseite (6) kleiner als der Durchmesser des Glasteiles ist, daß zwischen der Stirnseite (6) des Keramikringes und seinem Rand zur Bildung eines Kapillarsplates (9) für die Verschmelzung eine Abschrägung (8) liegt und daß zwischen der Stirnseite (6) des Keramikringes und dem elektrischen Leiter (4, 5) ein beim Verschmelzen zur Füllung mit Glas bestimmter Zwishenraum (10) liegt.

2. Glasdurchführung nach Anspruch 1, dadurch gekennzeichnet, daß der Keramikring (3) und das Glasteil (2) rund ausgebildet und konzentrisch zueinander angeordnet sind.

## Claims

1. A housing for a semiconductor power component comprising a glass element (2) which is seated in an opening in a metal housing element (1); a ceramic ring (3) located outside the metal housing element, the outer diameter of which is greater than the outer diameter of the glass element, and which, at least at one end face (6), is fused to an end face (7) of the glass element; and at least one electrical conductor (4, 5) which passes through the glass element and the ceramic ring, characterised in that the end face (6) of the ceramic ring (3) and the end face (7) of the glass element (2) are planar; that at said end face (6), the diameter of the ceramic ring is less than the diameter of the glass element; that between the end face (6) of the ceramic ring and the periphery thereof, a bevel is provided to form a capillary gap (9) for the fusion step; and that between the end face (6) of the ceramic ring and the electrical conductor (4, 5), a gap (10) is provided, which is intended to be filled with glass during the fusion step.

2. A glass bushing as claimed in Claim 1, characterised in that the ceramic ring (3) and the glass element (2) are circular and are arranged concentrically to one another.

## Revendications

1. Boîtier pour un composant à semiconducteurs de puissance, comportant un èlément der verre (2) monté dans une ouverture d'un élément de boîtier métallique (1), un anneau en céramique (3) monté à l'extérieur de l'élément de boîtier métallique, dont le diamètre extérieur est supérieur au diamètre de l'élément en verre et qui est soudé par fusion avec une face frontale (7) de l'élément en verre, au moins au niveau d'une face frontale (6), ainsi qu'au moins à un conducteur électrique (4, 5) passant par l'élément der verre et l'anneau en céramique, caractérisé par le fait que la face frontale (6) de l'anneau en céramique (3) et la face frontale (7) de l'élément en verre (2) sont planes, que le diamètre de l'anneau en céramique est, au niveau de ladite face frontale (6), inférieur au diamètre de l'élément en verre, qu'entre la face frontale (6) de l'anneau en céramique et son bord est prévu un biseau (8) pour former une fente capillaire (9) pour la soudure par fusion et qu'entre la face frontale (6) de l'anneau en céramique et le conducteur électrique (4, 5) se trouve un espace creux (10) destiné à être comblé avec du verre lors de la soudure par fusion.

2. Traversée en verre selon la revendication 1, caractérisée par la fait que l'anneau en céramique (3) et l'élément en verre (2) sont ronds et disposés concentriquement l'un par rapport à l'autre.

## Fig.1

## Fig.2